# EUROPEAN PATENT APPLICATION

(11) **EP 4 716 415 A1**
(43) Date of publication of application: **25.03.2026**
(21) Application number: 25200705.9
(22) Date of filing: 08.09.2025
(51) Int. Cl.: H10F 10/16, H10F 77/12

(54) **SOLAR CELL**

(30) Priority: 19.09.2024 JP 2024162735
(71) Applicant: KABUSHIKI KAISHA TOSHIBA, Kawasaki-shi, Kanagawa, 212-0013 (JP)
(72) Inventor: NAKAGAWA, Naoyuki, Kawasaki-shi, Kanagawa (JP); YAMAMOTO, Takashi, Kawasaki-shi, Kanagawa (JP); HONISHI, Yuya, Kawasaki-shi, Kanagawa (JP); YAMAMOTO, Kazushige, Kawasaki-shi, Kanagawa (JP)
(74) Representative: Hoffmann Eitle

(57) **Abstract**

A solar cell including a p-electrode, an n-electrode, a p-type light-absorbing layer on the p-electrode including a cuprous oxide compound as a main component, and an n-type layer between the p-type light-absorbing layer and the n-electrode. The p-type light-absorbing layer incudes a first element selected from the group consisting of Zn, Mg, Cd, and Ca on the n-type layer side. The p-type light-absorbing layer is in direct contact with the n-type layer. A concentration of the first element in a region from an interface between the p-type light-absorbing layer and the n-type layer to a depth of 50 [nm] or less toward the p-electrode side is 90 [atomic%] or more and 100 [atomic%] or less of a concentration of the first element included in the p-type light-absorbing layer.

## Description

### FIELD

Embodiments described herein relate generally to a solar cell, a multi-junction solar cell, a solar cell module, and a photovoltaic power generation system.

### BACKGROUND

One of new solar cells is a solar cell using a cuprous oxide (Cu₂O) for a light-absorbing layer. Cu₂O is a wide-gap semiconductor. Since Cu₂O is a safe and inexpensive material including copper which presents abundantly on the earth and oxygen, it is expected that a low-cost solar cell with high-efficiency can be realized.

### BRIEF DESCRIPTION OF THE DRAWINGS

FIG. 1 is a schematic cross-sectional diagram of a solar cell according to an embodiment;
FIG. 2 shows analysis spots of a solar cell according to an embodiment;
FIG. 3 is a schematic diagram showing a distribution of an intermediate film according to an embodiment;
FIG. 4 is a schematic diagram showing a compound distribution of an intermediate film according to an embodiment;
FIG. 5 is a schematic diagram showing a compound distribution of an intermediate film according to an embodiment;
FIG. 6 is a schematic diagram showing a compound distribution of an intermediate film according to an embodiment;
FIG. 7 is a schematic cross-sectional diagram of a multi-junction solar cell according to an embodiment;
FIG. 8 is a perspective diagram of a solar cell module according to an embodiment;
FIG. 9 is a schematic diagram of a solar cell module according to an embodiment;
FIG. 10 is a configuration diagram of a photovoltaic power generation system according to an embodiment;
FIG. 11 is a conceptual diagram of a vehicle according to an embodiment;
FIG. 12 is a schematic diagram of a drone according to an embodiment;
FIG. 13 is a table relating to examples;
FIG. 14 is a table relating to examples; and
FIG. 15 is a table relating to examples.

### DETAILED DESCRIPTION

A solar cell including a p-electrode, an n-electrode, a p-type light-absorbing layer on the p-electrode including a cuprous oxide compound as a main component, and an n-type layer between the p-type light-absorbing layer and the n-electrode. The p-type light-absorbing layer incudes a first element selected from the group consisting of Zn, Mg, Cd, and Ca on the n-type layer side. The p-type light-absorbing layer is in direct contact with the n-type layer. A concentration of the first element in a region from an interface between the p-type light-absorbing layer and the n-type layer to a depth of 50 [nm] or less toward the p-electrode side is 90 [atomic%] or more and 100 [atomic%] or less of a concentration of the first element included in the p-type light-absorbing layer.

Hereinafter, an embodiment will be described in detail with reference to the drawings. Unless otherwise specified, values at 25[°C] and 1 atm (atmosphere) are described. An average represents an arithmetic mean value. Each concentration is an average concentration in the region or layer of interest. In each layer, the presence of a specific element is, for example, an element whose presence can be confirmed by SIMS (Secondary Ion Mass Spectrometry), and the absence of a specific element is, for example, an element whose presence cannot be confirmed by SIMS.

In the specification, "/" (slash) represents the division sign excluding "/" of "and/or" representing "or". In the specification, "·" (middle dot, dot operator) and "×" represent a multiplication sign. In the specification, "." (period) of a numerical value represents a decimal point.

The thickness and structure of members described in the specification can be known, for example, from one or more of images obtained by SEM (Scanning Electron Microscope), TEM (Transmission Electron Microscope), HAADF-STEM: High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEP, PL (Photoluminescence), XPS (X-ray Photoelectron Spectroscopy), or the like. These analysis methods are examples and do not negate the specific analytical methods described in the specification.

### (FIRST EMBODIMENT)

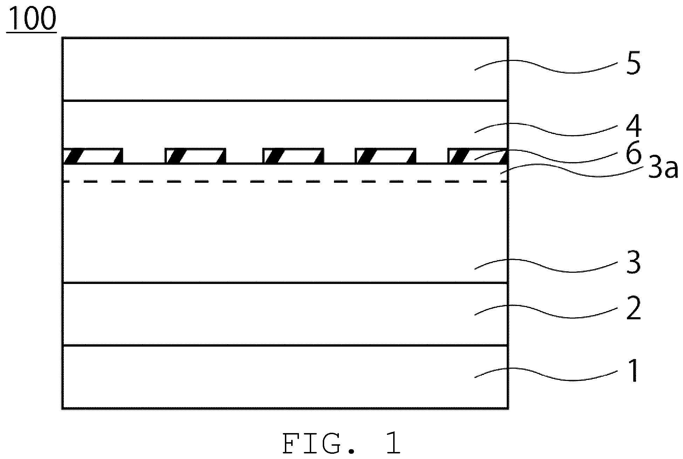

A first embodiment relates to an solar cell. FIG. 1 shows a schematic cross-sectional diagram of a solar cell 100 according to the first embodiment. As shown in FIG. 1 the solar cell 100 according to this embodiment comprises a substrate 1; a p-electrode 2 that is a first electrode; a p-type light-absorbing layer 3; an n-type layer 4; a second electrode that is an n-electrode 5; and an intermediate film 6. An intermediate layer(s) not shown in the figure may be incorporated between the n-type layer 4 and the n-electrode 5. Sunlight may enter from either the n-electrode 5 side or the p-electrode 2 side, but it is preferable for sunlight to enter from the n-electrode 5 side. The solar cell 100 of this embodiment is a translucent solar cell and is therefore preferably used as the top cell side (light incident side) of a multi-junction solar cell. The following description will be given with reference to the configuration shown in FIG. 1, but a configuration where the substrate 1 is located at a different position is similarly applicable even when the substrate 1 is provided on the n-electrode 5 side. In the solar cell 100 of this embodiment, light enters from the n-electrode 5 side toward the p-electrode 2 side.

When transparent electrodes are used for the p-electrode 2 and the n-electrode 5 in the embodiment of the solar cell 100, the transmittance of light in a wavelength band of 700 [nm] or more and 1200 [nm] or less is high, and the color of the solar cell may be red (reddish brown), yellow, or orange.

The substrate 1 is a transparent substrate. As the substrate 1 with light-transmittance, acrylic, polyimide, polycarbonate, polyethylene terephthalate (PET), polypropylene (PP), fluororesin (polytetrafluoroethylene (PTFE), perfluoroethylene propylene copolymer (FEP), ethylene tetrafluoroethylene copolymer (ETFE), polychlorotrifluoroethylene (PCTFE), perfluoroalkoxy alkane (PFA)), polyarylate, polysulfone, polyethersulfone, polyetherimide or inorganic substrate such as soda lime glass, float glass, chemically strengthened glass and quartz can be used. The substrate 1 may be a laminated body of the above substrates (materials).

The p-electrode 2 is provided on the substrate 1 and is arranged between the substrate 1 and the insulating film 3. The p-electrode 2 is a planar conductive film. The p-electrode 2 is conductive layer having light transmittance. The p-electrode 2 preferably includes one or more layers of transparent conductive oxide films.

The transparent conductive oxide film is not particularly limited, and is one or more semiconductor layers selected from the group consisting of an indium tin oxide (ITO), an Al-doped zinc oxide (AZO), a boron-doped zinc oxide (BZO), a gallium-doped zinc oxide (GZO), a doped tin oxide, a titanium-doped indium oxide (ITiO), an indium zinc oxide (IZO), an indium gallium zinc oxide (IGZO), a hydrogen-doped indium oxide (IOH), and the like. The transparent conductive oxide film may be a laminated film having multiple layers. A dopant for a film of tin oxide or the like is not particularly limited as long as the dopant is one or more elements selected from the group consisting of In, Si, Ge, Ti, Cu, Sb, Nb, Ta, W, Mo, F, Cl, and the like. The p-electrode 2 preferably includes the doped tin oxide which is doped with one or more elements selected from the group consisting of In, Si, Ge, Ti, Cu, Sb, Nb, Ta, W, Mo, F, Cl, and the like. Considering heat resistance, it is preferable to use the Sb-doped tin oxide film for the p-electrode 2. In the doped tin oxide film, one or more elements selected from the group consisting of In, Si, Ge, Ti, Cu, Sb, Nb, Ta, W, Mo, F, Cl, and the like are preferably included in an amount of 10 atomic % or less with respect to Zn included in the doped tin oxide film. As for the p-electrode 2, a laminated film of the transparent conductive oxide film and a metal film can be used. The metal film of the p-electrode 2 preferably has a thickness of 1 [nm] or more and 500 [µm] or less. The metal (including alloys) included in the metal film is not particularly limited to Mo, Au, Cu, Ag, Al, Ta, and W. Additionally, the p-electrode 2 may include dot-shaped, line-shaped, or mesh-shaped electrodes (one or more selected from the group consisting of metals, alloys, graphene, conductive nitrides, and transparent conductive oxides) between the transparent conductive oxide film and the substrate 1. The dot-shaped metal, line-shaped metal, or mesh-shaped metal preferably has an opening ratio of 50% or more with respect to the transparent conductive oxide film. The dot-shaped metal, line-shaped metal, or mesh-shaped metal is not particularly limited to Mo, Au, Cu, Ag, Al, Ta, or W. When the metal film is used for the p-electrode 2, the metal film preferably has a thickness of about 5 [nm] or less from the viewpoint of light transmittance. When the line-shaped or mesh-shaped metal film is used, above limitation does not apply to the film thickness of the metal film since light transmittance is secured at the openings.

It is preferable that a doped tin oxide film which forms an ohmic junction with the p-type light-absorbing layer 3 is provided on the outermost surface of the p-type light-absorbing layer 3 side of the oxide transparent conductive film. It is preferable that at least a portion of the doped tin oxide film provided on the p-type light-absorbing layer 3 side of the oxide transparent conductive film is in direct contact with the p-type light-absorbing layer 3.

The p-type light-absorbing layer 3 is an overall p-type semiconductor layer. The p-type light-absorbing layer 3 is provided on the p-electrode 2. The p-type light-absorbing layer 3 may be in direct contact with the p-electrode 2, or other layers may exist as long as electrical contact between the p-type light-absorbing layer 3 and the p-electrode 2 can be ensured. The p-type light-absorbing layer 3 is disposed between the p-electrode 2 and the n-type layer 4. A portion (not entire of) of the surface of the p-type light-absorbing layer 3 facing the n-type layer 4 side is in direct contact with the n-type layer 4. The p-type light-absorbing layer 3 which is in direct contact with the n-type layer 4 preferably forms a pn junction with the n-type layer 4. The p-type light-absorbing layer 3 comprises a cuprous oxide compound as a main component of the p-type light-absorbing layer 3. It is preferable that the cuprous oxide compound has a chalcopyrite structure.

It is preferable that the p-type light-absorbing layer 3 is a semiconductor layer comprising the cuprous oxide compound. It is preferable that the p-type light-absorbing layer 3 is polycrystalline of the cuprous oxide compound. The p-type light-absorbing layer 3 may include, in trace amounts, one or more types of impurities selected from the group consisting of copper (Cu), copper oxide (CuO) and copper hydroxide (Cu(OH)₂) as impurities.

When all elements excluding oxygen are defined as 100% included in the p-type light-absorbing layer, the copper element included in the p-type light-absorbing layer 3 is preferably 90% or more and less than 100%, more preferably 95[%] or more and less than 100%, even more preferably 98% or more and less than 100[%], and further more preferably 99% or more and less than 100%.

The cuprous oxide compound comprises copper, oxygen, and optionally an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, and Ca.

The number of oxygen atoms included in the cuprous oxide compound is preferably 0.48 or more and 0.56 or less when the number of copper atoms is defined as 1. When there is excess oxygen compared to copper, the ratio of cuprous oxide included in the cuprous oxide compound increases, resulting in a narrower band gap and reduced transmittance of the p-type light-absorbing layer 3. When there is insufficient oxygen compared to copper, the transmittance decreases due to an increase in the amount of copper included in the cuprous oxide compound. Moreover, when the ratio of oxygen to copper does not fall within the above range, it becomes difficult for the cuprous oxide compound to have a chalcopyrite structure

It is preferable that 95% or more and less than 100% of the p-type light-absorbing layer 3 is composed of the cuprous oxide compound, more preferably 98% or more and less than 100[%], and even more preferably 99% or more and less than 100[%]. The p-type light-absorbing layer 3 can be entirely composed of the cuprous oxide compound (cuprous oxide compound 100%).

When the p-type light-absorbing layer 3 has a small number of heterogeneous phases and good crystallinity, the transmittance of the p-type light-absorbing layer 3 is increased, which is preferable. The band gap of the p-type light-absorbing layer 3 can be adjusted by including elements other than Cu and O in the p-type light-absorbing layer 3. It is preferable that the band gap of the p-type light-absorbing layer 3 is 2.0 [eV] or more and 2.2 [eV] or less. In a multi-junction solar cell, when Si is used as a light absorption layer for the bottom cell and the embodiment solar cell is used for the top cell, solar light can be efficiently utilized in both the top cell and the bottom cell within this band gap range. It is preferable that the p-type light-absorbing layer 3 includes Sn or/and Sb. The Sn or Sb in the p-type light-absorbing layer 3 may be added to the p-type light-absorbing layer 3, or it may originate from the p-electrode 2. The Ga included in the p-type light-absorbing layer 3 is not included in the raw material for forming the p-type light-absorbing layer 3, but is Ga diffused from the n-type layer 4 into the p-type light-absorbing layer 3. When other elements are used during the film formation of the n-type layer 4, these elements may also diffuse into the p-type light-absorbing layer 3.

The compositional ratio of the p-type light-absorbing layer 3 described above is the overall compositional ratio of the p-type light-absorbing layer 3. It is preferable that the aforementioned compositional ratio of the p-type light-absorbing layer 3 is satisfied throughout the p-type light-absorbing layer 3.

It is preferable that the p-type light-absorbing layer 3 has a p+ (p plus) region on the p-electrode 2 side.

It is preferable that the p-type light-absorbing layer 3 has a p- (p minus) region on the n-type layer 4 side.

It is preferable that the p-type light-absorbing layer 3 has the p- (p minus) region on the n-type layer 4 side and the p+ (p plus) region on the p-electrode 2 side.

It is preferable that the p-type light-absorbing layer 3 includes one or more first elements selected from the group consisting of Zn, Mg, Cd and Ca on the n-type layer 4 side. When the p-type light-absorbing layer 3 includes one or more first elements selected from the group consisting of Zn, Mg, Cd and Ca on the n-type layer 4 side, a solar cell with high FF and Voc can be obtained when an intermediate film 6 is included.

Zn as the first element is preferably included in a region 3a. Mg as the first element is preferably included in the region 3a. Cd as the first element is preferably included in the region 3a. Ca as the first element is preferably included in the region 3a. Zn as the first element is at least included in the region 3a and one or more elements selected from the group consisting of Mg, Cd, and Ca may be further included, preferably.

It is preferable that the first element be included in a region 3a which extends from the interface between the p-type light-absorbing layer 3 and the n-type layer 4 to a depth of 50 [nm] or less toward the p-electrode 2 side but not extends over the interface and the depth of 50 [nm]. From the viewpoint of obtaining a solar cell with high FF and Voc, the region 3a is preferably included intendedly.

It is preferable that the first element is not in a metallic state but rather included in the p-type light-absorbing layer 3. The valence number of Zn, the first element, in the p-type light-absorbing layer 3 is preferably 2. The valence number of Mg, the first element, in the p-type light-absorbing layer 3 is preferably 2. The valence number of Cd, the first element, in the p-type light-absorbing layer 3 is preferably 2. The valence number of Ca, the first element, in the p-type light-absorbing layer 3 is preferably 2.

From the viewpoint of obtaining a solar cell with high FF and Voc, it is preferable that the concentration of the first element included in the region 3a is 90 [atomic%] or more and 100 [atomic%] or less of the concentration of the first element included in the p-type light-absorbing layer 3 (the whole of the p-type light-absorbing layer 3). The concentration of the first element included in the region 3a is more preferably 95 [atomic%] or more and 100 [atomic%] or less of that, and further more preferably 98 [atomic%] or more and 100 [atomic%] or less of that.

From the viewpoint of obtaining a solar cell with high FF and Voc, it is preferable that the concentration of the first element included in the region 3a is 90 [atomic%] or more and less than 100 [atomic%] in the p-type light-absorbing layer 3 (the whole of the p-type light-absorbing layer 3). The concentration of the first element included in the region 3a is more preferably 95 [atomic%] or more and less than 100 [atomic%] of that, and further more preferably 98 [atomic%] or more and less than 100 [atomic%] of that.

It is preferable that the concentration of the first element included in the region 3a is 1 [atomic%] or more and 10 [atomic%] or less of the concentration of copper element included in the region 3a. The concentration of the first element included in the region 3a is more preferably 2 [atomic%] or more and 5 [atomic%] or less of the concentration of copper element included in the region 3a, and further more preferably 2 [atomic%] or more and 3 [atomic%] or less of the concentration of copper element included in the region 3a.

When elements of the n-type layer 4 diffuse into the p-type light-absorbing layer 3, or/and elements of the p-type light-absorbing layer 3 diffuse into the n-type layer 4, there may exist a mixed region with a thickness of 20 [nm] or less where elements of each other are diffused between the p-type light-absorbing layer 3 and the n-type layer 4. In the mixed region, 90 [atomic%] or less of the metal element is the metal element included in the p-type light-absorbing layer 3, and further, 10 [atomic%] or more of the metal element is the metal element included in the n-type layer 4. When the mixed region exists, the surface of the p-type light-absorbing layer 3 including the mixed region on the n-type layer 4 side is positioned based on the position of the surface of the intermediate film 6 on the p-electrode 2 side.

The thickness of the p-type light-absorbing layer 3 is determined by observation of a cross section with an electron microscope or measurement with a step profiler, and preferably 2000 [nm] or more and 15000 [nm] or less (2 [µm] or more and 15 [µm] or less). More preferably, the thickness of the p-type light-absorbing layer 3 is 2500 [nm] or more and 10000 [nm] or less. Even more preferably, the thickness of the p-type light-absorbing layer 3 is 4000 [nm] or more and 10000 [nm] or less, and most preferably 4000 [nm] or more and 8000 [nm] or less. The p-type light-absorbing layer 3 preferably has a small height difference on the surface; the difference between the minimum thickness and maximum thickness of the p-type light-absorbing layer 3 is preferably 0 [nm] or more and 100 [nm] or less, and more preferably 0 [nm] or more and 50 [nm] or less.

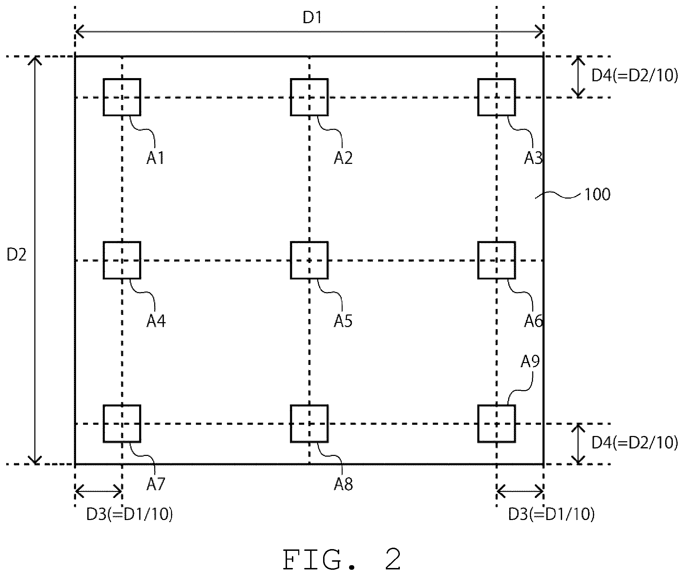

The composition analysis of the p-type light-absorbing layer 3 and the like can be determined, for example, by analyzing analysis spots (A1 to A9) shown in FIG. 2 distributed as evenly as possible at equal intervals, using secondary ion mass spectrometry (SIMS), for example. FIG. 2 is a schematic diagram showing the solar cell 100 viewed from the light incidence side. When analyzing the composition of the p-type light-absorbing layer 3, D1 is the width length of the p-type light-absorbing layer 3 and D2 is the depth length of the p-type light-absorbing layer 3. The composition analysis is performed, for example, from the surface of the n-type layer 4 towards the p-electrode 2.

The composition of the p-type light-absorbing layer 3 is determined as follows. "d1" represents the thickness of the p-type light-absorbing layer 3. The composition at each of positions at a first depth, a second depth, a third depth, a fourth depth, a fifth depth, a seventh depth, an eighth depth, and a ninth depth is calculated, and an average value of calculated values at every position is the average composition ratio. The first depth is a depth of 0.1d₁ (0.1 times d₁) in the direction toward the p-electrode 2 from the surface of the p-type light-absorbing layer 3 on the n-type layer 4 side. The second depth is a depth of 0.2d₁ (0.2 times d₁) in the direction toward the p-electrode 2 from the surface of the p-type light-absorbing layer 3 on the n-type layer 4 side. The third depth is a depth of 0.3d₁ (0.3 times d₁) in the direction toward the p-electrode 2 from the surface of the p-type light-absorbing layer 3 on the n-type layer 4 side. The fourth depth is a depth of 0.4d₁ (0.4 times d₁) in the direction toward the p-electrode 2 from the surface of the p-type light-absorbing layer 3 on the n-type layer 4 side. The fifth depth is a depth of 0.5d₁ (0.5 times d₁) in the direction toward the p-electrode 2 from the surface of the p-type light-absorbing layer 3 on the n-type layer 4 side. The sixth depth is a depth of 0.6d₁ (0.6 times d₁) in the direction toward the p-electrode 2 from the surface of the p-type light-absorbing layer 3 on the n-type layer 4 side. The seventh depth is a depth of 0.7d₁ (0.7 times d₁) in the direction toward the p-electrode 2 from the surface of the p-type light-absorbing layer 3 on the n-type layer 4 side. The eighth depth is a depth of 0.8d₁ (0.8 times d₁) in the direction toward the p-electrode 2 from the surface of the p-type light-absorbing layer 3 on the n-type layer 4 side. The ninth depth is a depth of 0.9d₁ (0.9 times d₁) in the direction toward the p-electrode 2 from the surface of the p-type light-absorbing layer 3 on the n-type layer 4 side. For SIMS analysis, it is preferable to analyze the p-type light-absorbing layer 3 starting from a depth of 0.1d₁ because elements from the n-type layer 4 are easily detected when analyzing the surface of the p-type light-absorbing layer 3.

The p-type light-absorbing layer 3 is preferably formed by a sputtering method, for example. More specifically, a member with the substrate 1 and the p-electrode 2 formed on the substrate 1, is heated to 300 [°C] or more and 1000 [°C] or less, and oxygen partial pressure is set within the range of 0.01 [Pa] or more and 4.8 [Pa] or less, and deposition is performed at a rate within the range of 0.02 [µm/min] or more and 20 [µm/min] or less. In order to form a polycrystalline film with high transparency and large grain size, it is preferable that the oxygen partial pressure satisfies 0.20 x d [Pa] or more and 1.00 × d [Pa] or less (for example, in the case of high-temperature sputtering, 0.20 × d [Pa] or more and 0.50 × d [Pa] or less is preferable, and in the case of low-temperature sputtering, 0.55 × d [Pa] or more and 1.00 × d [Pa] or less is preferable), where d is the deposition rate for the p-type light-absorbing layer 3. The heating temperature of the member is preferably 350 [°C] or more and 600 [°C] or less. Element M1 can be added during the formation of the p-type light-absorbing layer 3. After forming the p-type light-absorbing layer 3, an oxidation treatment may be performed on the side where the intermediate film 6 and the n-type layer 4 are formed before the intermediate film 6 and the n-type layer 4 are formed.

The n-type layer 4 is an n-type semiconductor layer. The n-type layer 4 is preferably provided between the p-type light-absorbing layer 3 and the n-electrode 5. The n-type layer 4 is preferably provided on the p-type light-absorbing layer 3. The n-type layer 4 can be formed, for example, by an atomic layer deposition (ALD) method.

It is preferable that the n-type layer 4 includes a compound (oxide) including Ga as a main component. The n-type layer 4 may include other oxides mixed with the Ga-based oxide, or other elements may be doped into the Ga-based oxide, or other elements may be doped with the Ga-based oxide and other oxides mixed. The n-type layer 4 can be a single layer or a multilayer. Among the metal elements included in the n-type layer 4, it is preferable that Ga is 40 [atomic%] or more, and more preferably 50 [atomic%] or more.
The metal element including Ga in the n-type layer 4 may be inclined from the p-type light-absorbing layer 3 side to the n-electrode 5 side.
When the n-type layer 4 is a multilayer semiconductor layer (for example, two layers), the first n-type layer, located closer to the p-type light-absorbing layer 3, and the second n-type layer, located further from the p-type light-absorbing layer 3, are provided on the p-type light-absorbing layer 3. It is preferable that the element M2 included in the first n-type layer is smaller than the element M2 included in the second n-type layer.

The n-type layer 4 preferably includes an oxide including Ga and an element represented by M2. For example, the Ga-based oxide is an oxide including Ga and an element represented by M2. The n-type layer 4 preferably includes an oxide including Ga and an element M2 selected from one or more elements of the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd. The n-type layer 4 preferably includes 90 wt% or more and 100 wt% or less of an oxide including Ga and an element M2 selected from one or more elements of the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd. The average composition of the Ga-based compound in the n-type layer 4 is preferably represented by Gaₕ₁M2ᵢ₁Oⱼ₁. Preferably, h1, i1, and j1 satisfy 1.8 ≤ h1 ≤ 2.1, 0.0 ≤ i1 ≤ 0.2, and 2.9 ≤ j1 ≤ 3.1.

Preferably, 90 [wt%] or more and 100 [wt%] or less of the n-type layer 4 is an oxide including Ga and an element M2. More preferably, 95 [wt%] or more and 100 [wt%] or less of the n-type layer 4 is an oxide including Ga and an element M2. Even more preferably, 98 [wt%] or more and 100 [wt%] or less of the n-type layer 4 is a compound represented by an oxide including Ga and an element M2. The Cu included in the n-type layer 4 is not included in the raw materials for forming the n-type layer 4 but diffused from the Cu included in the p-type light-absorbing layer 3. When other elements are also used during the formation of the p-type light-absorbing layer 3, these elements may also diffuse into the n-type layer 4.

The thickness of the n-type layer 4 is typically 3 [nm] or more and 100 [nm] or less. When the thickness of the n-type layer 4 is less than 3 [nm], a leakage current may occur due to poor coverage of the n-type layer 4, which may degrade performance. When the coverage is good, it is not limited to this thickness range. When the thickness of the n-type layer 4 exceeds 50 [m,] performance degradation may occur due to excessive high resistance of the n-type layer 4 and a decrease in short circuit current due to reduced transmittance. Therefore, the thickness of the n-type layer 4 is more preferably 3 [nm] or more and 20 [nm] or less, and even more preferably 5 [nm] or more and 20 [nm] or less.

The composition of the compound in the n-type layer 4 is the average composition of the entire n-type layer 4 unless otherwise specified. The composition of the n-type layer 4 is, assuming that the thickness of the n-type layer 4 is d4, the average value of a composition at a depth of 0.2d4 (0.2 times d4) from the surface of the n-type layer 4 on the p-type light-absorbing layer 3 side towards the direction of the n-electrode 5, and a composition at a depth of 0.5d4 (0.5 times d4) from the surface of the n-type layer 4 on the p-type light-absorbing layer 3 side towards the direction of the n-electrode 5, and a composition at a depth of 0.8d4 (0.8 times d4) from the surface of the n-type layer 4 on the p-type light-absorbing layer 3 side towards the direction of the n-electrode 5. Unless there are conditions that the elemental composition ratio of the compound in the n-type layer 4 is inclined, it is preferable that the above and below preferred compositions are satisfied for each depth. When the n-type layer 4 is very thin (for example, 5 nm or less), the composition at a depth of 0.5d4 from the surface of the n-type layer 4 towards the direction of the n-electrode 5 can be considered as the overall composition of the n-type layer 4. Analysis is performed by analyzing, for example, using secondary ion mass spectrometry (SIMS), analysis spots (A1 to A9) distributed as uniformly spaced as possible over the distance from the surface of the n-type layer 4 according to the explanation diagram shown in FIG. 2. FIG. 2 is a schematic diagram showing the solar cell 100 viewed from the light incidence side. When analyzing the composition of the n-type layer 4, D1 is the length in the width direction of the n-type layer 4 and D2 is the length in the depth direction of the n-type layer 4.

The average composition of a region with a depth of 1 [nm] from the surface (starting point) on the p-type light-absorbing layer 3 side of the n-type layer 4 is represented by Gaₕ₂M3ᵢ₂Oⱼ₂, preferably. Preferably, h2, i2, and j2 satisfy 1.8 ≤ h2 ≤ 2.1, 0.00 ≤ i2 ≤ 0.05, and 2.9 ≤ j2 ≤ 3.1; more preferably, 1.8 ≤ h2 ≤ 2.1, 0.00 ≤ i2 ≤ 0.03, and 2.9 ≤ j2 ≤ 3.1; and even more preferably, 1.8 ≤ h2 ≤ 2.1, 0.00 ≤ i2 ≤ 0.01, and 2.9 ≤ j2 ≤ 3.1. Preferably, M3 is one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd. Preferably, M3 is one or more elements selected from the group consisting of H, Sn, Sb, Cu, Ag, Li, Na, K, Cs, Rb, In, Zn, Mg, Si, Ge, N, Ti, Ca, Ce, La, Pr, and Nd. It is preferable that 1.8 ≤ h2 ≤ 2.1, i2 = 0, and 2.9 ≤ j2 ≤ 3.1 in a region with from the surface (starting point) on the p-type light-absorbing layer 3 side of the n-type layer 4 to a depth of 1 [nm] (ending point) toward the p-type light-absorbing layer 3.

The intermediate film 6 is further provided between the p-type light-absorbing layer 3 and the n-type layer 4. Preferably, the cuprous oxide compound is in direct contact with the intermediate film 6 and the n-type layer 4. Preferably, the intermediate film 6 to be distributed island-like between the p-type light-absorbing layer 3 and the n-type layer 4. More preferably, the surface of the intermediate film 6 facing the p-type light-absorbing layer 3 is in direct contact with the p-type light-absorbing layer 3. More preferably, one or more surfaces other than the surface of the intermediate film 6 facing the p-type light-absorbing layer 3 is in direct contact with the n-type layer 4. Even more preferably, all surfaces other than the one or more surfaces of the intermediate film 6 facing the p-type light-absorbing layer 3 in direct contact with the n-type layer 4. Preferably, the coverage ratio (the area on which the intermediate film 6 is in contact with the p-type light-absorbing layer 3 divided by the area of the surface of the p-type light-absorbing layer 3 on the side facing the n-type layer 4) is 10% or more and less than 100%. In other words, the intermediate film 6 has (opposing each other) surfaces. The surfaces of the intermediate film 6 include inclined or curved surfaces in a direction perpendicular to the stacking direction of the p-type light-absorbing layer 3 and the n-type layer 4. Preferably, one or more side surfaces of the intermediate film 6 is in direct contact with the n-type layer 4. Preferably, every side surface of the intermediate film 6 is in direct contact with the p-type light-absorbing layer 3 or/and the n-type layer 4. In a portion where the intermediate film 6 does not exist between the p-type light-absorbing layer 3 and the n-type layer 4, the p-type light-absorbing layer 3 and the n-type layer 4 are directly in contact with each other.

Preferably, the intermediate film 6 is present so as to extend in the surface direction of the p-type light-absorbing layer 3 on the side facing the n-type layer 4. Preferably, the intermediate film 6 is not included within the p-type light-absorbing layer 3 and the n-type layer 4. In other words, the intermediate film 6 that is not in direct contact with the surface of the p-type light-absorbing layer 3, does not exist in the solar cell 100, preferably. In other words, the intermediate film 6 that is not in direct contact with the surface of the n-type layer 4, does not exist in the solar cell 100.

It is preferable for the intermediate film 6 to be an insulator. The intermediate film 6 is a material having high resistance in the stacking direction (the stacking direction of the p-type light-absorbing layer 3 and the n-type layer 4). The intermediate film 6 preferably includes a compound of a second element. The intermediate film 6 preferably includes an oxide, nitride, or sulfide of the second element. The intermediate film 6 preferably includes an oxide of the second element. Since the intermediate film 6 exists in a very small region, it is difficult to determine whether the oxygen at the end of the region where the intermediate film 6 exists should be considered as oxygen of the n-type layer 4 or oxygen of the intermediate film 6 when the intermediate film 6 is an oxide. Therefore, when expressing the composition of the compound of the second element included in the intermediate film 6 in the embodiments and examples (for example, Alₓ₁Hfₓ₂Zrₓ₃Bₓ₄O_{y}, Alₓ₁O_{y}, Hfₓ₂O_{y}, Zrₓ₃O_{y}, Bₓ₄O_{y}, etc. satisfies following compositional ratios), the composition of the intermediate film 6 is expressed with a numerical range(s).

The intermediate film 6 preferably includes a first element in addition to the compound of the second element. The first element included in the intermediate film 6 is included as, for example, a compound of the first element. The compound of the first element is, for example, an oxide, nitride, or sulfide of the first element. The intermediate film 6 preferably includes an oxide of the first element as the compound of the first element.

The cuprous oxide compound of the p-type light-absorbing layer 3 is preferably in direct contact with the compound of the first element of the intermediate film 6 and the n-type layer 4.

The cuprous oxide compound of the p-type light-absorbing layer 3 is preferably in direct contact with the compound of the second element of the intermediate film 6 and the n-type layer 4.

The cuprous oxide compound of the p-type light-absorbing layer 3 is preferably in direct contact with the compound of the first element, the compound of the second element of the intermediate film 6, and the n-type layer 4.

The second element is preferably one or more elements selected from the group consisting of Al, Hf, Zr, and B. The second element is preferably Al, Hf, Zr, or B.

The concentration of the first element included in the intermediate film 6 is preferably 5 [atomic%] or more and 50 [atomic%] or less of the first element included in the p-type light-absorbing layer 3, more preferably 5 [atomic%] or more and 20 [atomic%] or less, and even more preferably 5 atomic% or more and 10 atomic% or less. The first element diffuses more easily into the p-type light-absorbing layer 3 than the second element, and the first element is included in a larger amount in the p-type light-absorbing layer 3. The second element is difficult to diffuse into the p-type light-absorbing layer 3, and the second element of the intermediate film 6 hardly diffuses into the p-type light-absorbing layer 3.

Among the metal elements included in the intermediate film 6, the concentration the first element is preferably 5 [atomic%] or more and 50 [atomic%] or less, more preferably 5 [atomic%] or more and 20 [atomic%] or less, and even more preferably 5 [atomic%] or more and 10 [atomic%] or less.

The total concentration of the first element and the second element among the metal elements included in the intermediate film 6 is preferably 95 [atomic%] or more and 100 [atomic%] or less, more preferably 98 [atomic%] or more and 100 [atomic%] or less, and even more preferably 99 [atomic%] or more and 100 [atomic%] or less.

The intermediate film 6 preferably includes a compound represented by Alₓ₁Hfₓ₂Zrₓ₃Bₓ₄O_{y}. x1, x2, x3, x4 and y of the compound represented by Alₓ₁Hfₓ₂Zrₓ₃Bₓ₄O_{y} satisfy preferably 0.8 ≤ x1 + x2 + x3 + x4 ≤ 1.2 and 0.3 ≤ (x1 + x2 + x3 + x4) / y ≤ 0.8, more preferably 0.9 ≤ x1 + x2 + x3 + x4 ≤ 1.1 and 0.4 ≤ (x1 + x2 + x3 + x4) / y ≤ 0.7, and even more preferably 0.95 ≤ x1 + x2 + x3 + x4 ≤ 1.05 and 0.6 ≤ (x1 + x2 + x3 + x4) / y ≤ 0.7.

The intermediate film 6 preferably includes a compound represented by Alₓ₁Hfₓ₂Zrₓ₃Bₓ₄O_{y}. When Al is included in the compound represented by Alₓ₁Hfₓ₂Zrₓ₃Bₓ₄O_{y} as a main component, x1, x2, x3, and x4 of the compound represented by Alₓ₁Hfₓ₂Zrₓ₃Bₓ₄O_{y} satisfy preferably 0.8 ≤ x1 / (x1 + x2 + x3 + x4) ≤ 1.0, and more preferably 0.9 ≤ x1 / (x1 + x2 + x3 + x4) ≤ 1.0.

The intermediate film 6 preferably includes a compound represented by Alₓ₁O_{y}. When the intermediate film 6 includes the compound represented by Alₓ₁O_{y}, x1 and y of the compound represented by Alₓ₁O_{y} satisfy preferably 0.5 ≤ x1/y ≤ 0.8, and more preferably 0.6 ≤ x1/y ≤ 0.7.

The intermediate film 6 preferably includes a compound represented by Alₓ₁Hfₓ₂Zrₓ₃Bₓ₄O_{y}. When Hf is included in the compound represented by Alₓ₁Hfₓ₂Zrₓ₃Bₓ₄O_{y} as a main component, x1, x2, x3, and x4 of the compound represented by Alₓ₁Hfₓ₂Zrₓ₃Bₓ₄O_{y} satisfy preferably 0.8 ≤ x2 / (x1 + x2 + x3 + x4) ≤ 1.0, and more preferably 0.9 ≤ x2 / (x1 + x2 + x3 + x4) ≤ 1.0.

The intermediate film 6 preferably includes a compound represented by Hfₓ₂O_{y}. When the intermediate film 6 includes the compound represented by Hfₓ₂O_{y}, x2 and y of the compound represented by Hfₓ₂O_{y} satisfy preferably 0.3 ≤ x2/y ≤ 0.7, and more preferably 0.4 ≤ x2/y ≤ 0.6.

The intermediate film 6 preferably includes a compound represented by Alₓ₁Hfₓ₂Zrₓ₃Bₓ₄O_{y}. When Zr is included in the compound represented by Alₓ₁Hfₓ₂Zrₓ₃Bₓ₄O_{y} as a main component, x1, x2, x3, and x4 of the compound represented by Alₓ₁Hfₓ₂Zrₓ₃Bₓ₄O_{y} satisfy preferably 0.8 ≤ x3 / (x1 + x2 + x3 + x4) ≤ 1.0, and more preferably 0.9 ≤ x3 / (x1 + x2 + x3 + x4) ≤ 1.0.

The intermediate film 6 preferably includes a compound represented by Zrₓ₃O_{y}. When the intermediate film 6 includes the compound represented by Zrₓ₃O_{y}, x3 and y of the compound represented by Zrₓ₃O_{y} satisfy preferably 0.3 ≤ x3/y ≤ 0.7, and more preferably 0.4 ≤ x3/y ≤ 0.6.

The intermediate film 6 preferably includes a compound represented by Alₓ₁Hfₓ₂Zrₓ₃Bₓ₄O_{y}. When B is included in the compound represented by Alₓ₁Hfₓ₂Zrₓ₃Bₓ₄O_{y} as a main component, x1, x2, x3, and x4 of the compound represented by Alₓ₁Hfₓ₂Zrₓ₃Bₓ₄O_{y} satisfy preferably 0.8 ≤ x4 / (x1 + x2 + x3 + x4) ≤ 1.0, and more preferably 0.9 ≤ x4 / (x1 + x2 + x3 + x4) ≤ 1.0.

The intermediate film 6 preferably includes a compound represented by Bₓ₄O_{y}. When the intermediate film 6 includes the compound represented by Bₓ₄O_{y}, x4 and y of the compound represented by Bₓ₄O_{y} satisfy preferably 0.5 ≤ x4/y ≤ 0.8, and more preferably 0.6 ≤ x4/y ≤ 0.7.

The intermediate film 6 used in the examples also satisfies the preferable conditions for x1, x2, x3, x4 and y described above.

Since the intermediate film 6 is disposed between the p-type light-absorbing layer 3 and the n-type layer 4 with a coverage ratio (coverage of the p-type light-absorbing layer 3 by the intermediate film 6, more specifically, the area where the intermediate film 6 is in direct contact with the p-type light-absorbing layer 3 to an area on the n-type layer 4 side of the p-type light-absorbing layer 3) of less than 100%, a high fill factor (FF) and a high open-circuit voltage (Voc) can be achieved simultaneously, thereby contributing to the improvement of the solar cell conversion efficiency.

Compared to a solar cell configuration without the intermediate film 6, the oxygen in the cuprous oxide compound on the surface of the p-type light-absorbing layer 3 of the solar cell 100 of the embodiment is less likely to diffuse into the n-type layer 4 or be extracted, and the number of defects present on the surface of the p-type light-absorbing layer 3 is reduced even if defects exist. This is considered to contribute to the improvement of conversion efficiency.

Oxygen in cuprous oxide compounds tends to be extracted by the n-type layer 4, but it is thought that providing the intermediate film 6 reduces the extraction of oxygen from the cuprous oxide compound. When the n-type layer 4 thicker than the intermediate film 6 is formed after forming the intermediate film 6, the stability of the intermediate film 6 is high, and since a part of the surface of the p-type light-absorbing layer 3 is covered by the intermediate film 6, it is considered that the extracting oxygen by the n-type layer 4 from the cuprous oxide compound is reduced. As a result, it becomes possible to form the n-type layer 4 with reducing the formation of surface defects in the formed cuprous oxide compound during forming the n-type layer 4.

When the intermediate film 6 is thick, it becomes difficult to extract photo-carriers generated in the p-type light-absorbing layer 3 into the n-type layer 4. Therefore, the average thickness of the intermediate film 6 is preferably 0.2 [nm] or more and 1 [nm] (approximately one atomic layer) or less. Similarly, from the same viewpoint, the maximum thickness of the intermediate film 6 is preferably 0.2 [nm] or more and 1 [nm] or less, and more preferably 0.4 [nm] or more and 0.8 [nm] or less. The thickness of the intermediate film 6 can be determined by observing spots A1 to A9 at a high magnification (for example, 1 million times) with TEM (transmission electron microscope).

Considering the transmittance of the solar cell 100, it is preferable that the intermediate film 6 has a wide band gap and a thickness within the above range. Therefore, the band gap of the intermediate film 6 is preferably 5 [eV] or more and 10 [eV] or less, more preferably 6 [eV] or more and 9 [eV] or less.

In the portion where the intermediate film 6 exists on the p-type light-absorbing layer 3, it is preferable that a repeating pattern of bonding with the second element and an oxygen atom is included. In the portion where the intermediate film 6 does not exist on the p-type light-absorbing layer 3, when the n-type layer 4 includes gallium and oxygen, it is preferable that a repeating pattern of bonding with a gallium atom and an oxygen atom is included. Overall, when patterns of the first element, the second element, oxygen atom, and gallium atom in the interface of the p-type light-absorbing layer 3 and the n-type layer 4, are randomly repeated entirely without regularity, the oxide layer formed on the p-type light-absorbing layer 3 is an oxide of Ga and Al, which differs from the configuration of the embodiment.

While a passivation film is sometimes used at the p-n junction of a solar cell, this passivation film typically has a thickness of 3 [nm] or more. Such a thick film can be formed on a CIGS film having a chalcopyrite structure. However, even if CIGS films are used in other solar cells, when a passivation film with a thickness of 3 [nm] or more is used between the p-type light-absorbing layer 3 and the n-type layer 4 in a Cu₂O solar cell, the transmittance is good, but Jsc, Voc, FF, and conversion efficiency are significantly reduced. The intermediate film 6 is intentionally opened (coverage less than 100%) and its thickness is very thin, which differs from a passivation film with an average thickness of 3 [nm] or more. Moreover, the only purpose of the intermediate film 6 is to reduce the extraction of oxygen from the p-type light-absorbing layer 3 by the n-type layer 4, so it can be extremely thin.

From the above viewpoint, the coverage ratio is more preferably 10 [%] or more and less than 100 [%], more preferably 20 [%] or more and 85 [%] or less, even more preferably 30 [%] or more and 85 [%] or less, and further more preferably 50 [%] or more and 85 [%] or less. Even when the thickness of the intermediate film 6 is sufficiently thin, Voc is not substantially improved when the coverage ratio is low. Therefore, a coverage ratio of 10 [%] or more is preferred. The coverage ratio and the composition of the intermediate film 6 can be determined by analyzing the n-type layer 4 side with HAXPES (hard X-ray photoelectron spectroscopy) after removing the n-electrode 5 of the solar cell 100 by ion milling, for example.

The intermediate film 6 is formed on the p-type light-absorbing layer 3 using, for example, the ALD method, preferably. It is preferable that the n-type layer 4 is formed on the p-type light-absorbing layer 3 where a part of the surface is formed by the intermediate film 6.

The compounds (precursors) used in forming the intermediate film 6 using the ALD method are preferably one or more selected from the group consisting of diethyl zinc, bis(ethylcyclopentadienyl) magnesium, bis(2,2,6,6-tetramethyl-3,5-heptanedionato) calcium, and dimethyl cadmium, and one or more selected from the group consisting of trimethylaluminum, triethylaluminum, trisdimethylamidoaluminum, triethoxyaluminum, tetrakisdimethylaminohafnium, tetrakisethylmethylaminohafnium, tetrakisdiethylamino hafnium, tetrakisdimethylaminozirconium, tetrakisethylmethylaminozirconium, tetrakisdiethylaminozirconium, triethylboron, and trisdimethylaminoborane. In forming the intermediate film 6 using the ALD method, it is preferable to adjust the pulse irradiation time, etc., and supply a small amount of precursor for forming the intermediate film 6 with a thickness of less than 1 [nm], for example, less than one atomic layer, to the entire surface on the p-type light-absorbing layer 3 side where the n-type layer 4 will be formed. When manufacturing the solar cell 100 having the intermediate film 6, it is preferable to form a thin film by ALD by supplying a compound including the first element and water after forming a semiconductor layer mainly composed of the cuprous oxide, and then supplying a compound including the second element and water. When manufacturing the solar cell 100 having the intermediate film 6, it is preferable to form a thin film by ALD by supplying a compound including the first element, a compound including the second element, and water after forming a semiconductor layer mainly composed of cuprous oxide.

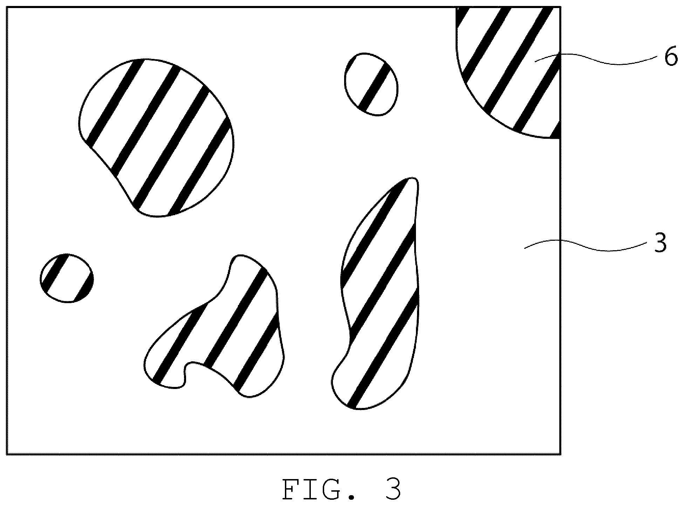

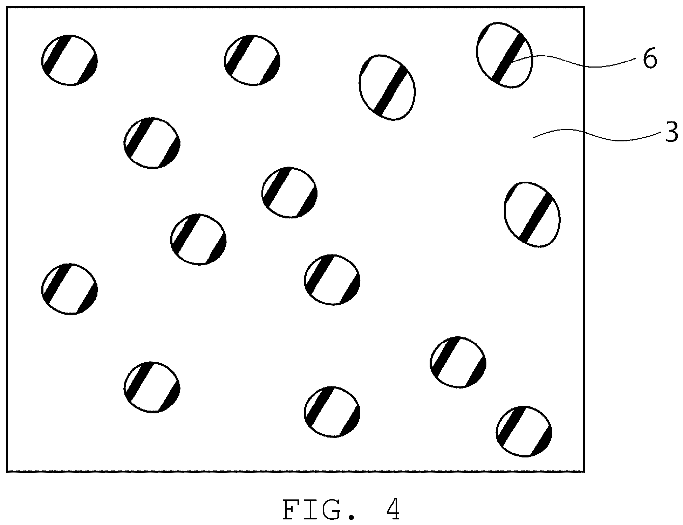

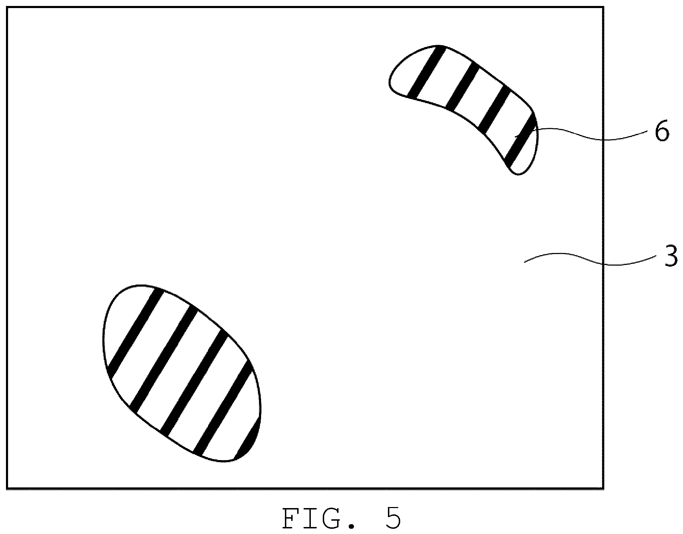

FIGS. 3 to 6 show diagrams of the distribution of the intermediate film 6. As shown in the figures, the morphology of the distribution of the intermediate film 6 is not particularly limited. A higher dispersion of the intermediate film 6 is preferable, but a biased intermediate film 6 as shown in FIG. 3 also contributes to an improvement in conversion efficiency. As shown in figures, the island-like distribution is interpreted broadly. The average area of the islands of the intermediate film 6 is preferably, for example, 10 [%] or more and less than 100 [%] of the area on the n-type layer 4 side of the p-type light-absorbing layer 3, more preferably 20 [%] or more and 85 [%] or less, and even more preferably 30 [%] or more and 85 [%] or less.

The n-electrode 5 is an electrode on the n-type layer 4 side that has light transmittance to visible light. It is preferable that the n-electrode 5 be provided on the n-type layer 4. The n-type layer 4 and the intermediate film 6 are sandwiched between the p-type light-absorbing layer 3 and the n-electrode 5. An intermediate layer not shown in the figures may be provided between the n-type layer 4 and the n-electrode 5. It is preferable to use an oxide transparent conductive film for the n-electrode 5. The oxide transparent conductive film used in the n-electrode 5 is preferably one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide and hydrogen-doped indium oxide. Dopants for oxide such as tin include one or more selected from the group consisting of In, Si, Ge, Ti, Cu, Sb, Nb, Ta, W, Mo, F and Cl without particular limitation. The n-electrode 5 may include a mesh or line-shaped electrode to reduce the resistance of the oxide transparent conductive film. Mo, Au, Cu, Ag, Al, Ta, or W can be used for the mesh or line-shaped electrodes, without particular limitation. Graphene can also be used in the n-electrode 5. The graphene is preferably laminated with silver nanowires.

The thickness of the n-electrode 5 can be determined by cross-sectional observation with an electron microscope and step measurement. It is not particularly limited, but typically 50 [nm] or more and 2 [µm] or less.

It is preferable that the n-electrode 5 be formed by ALD, sputtering, etc.

### (SECOND EMBODIMENT)

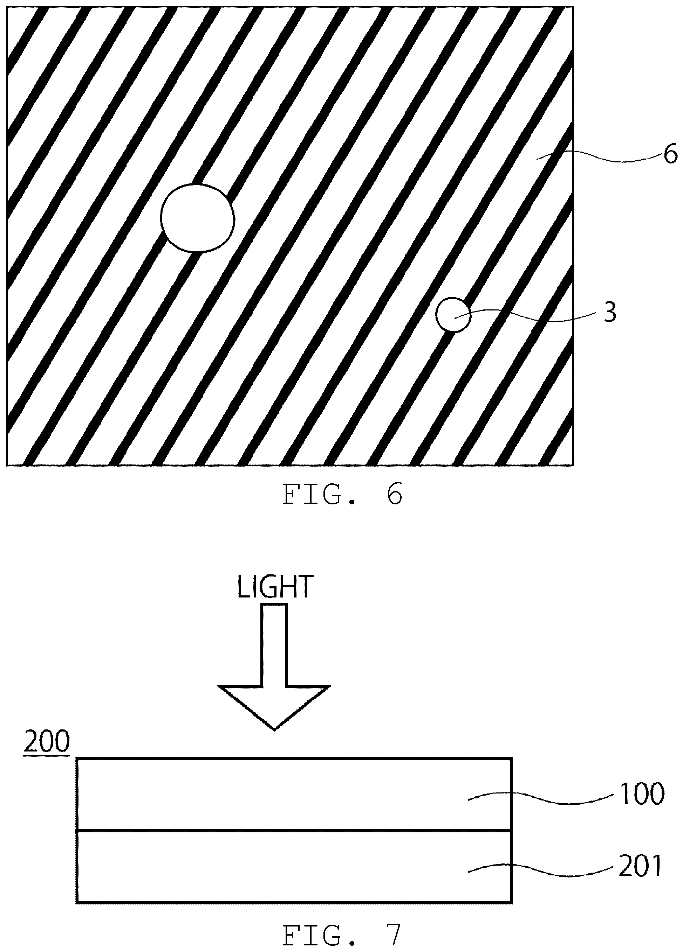

A second embodiment relates to a multi-junction solar cell. FIG. 7 shows a cross-sectional schematic diagram of the multi-junction solar cell according to this embodiment. The multi-junction solar cell 200 in FIG. 7 has a solar cell (a first solar cell) 100 according to the third embodiment on the light incident side and a second solar cell 201. The band gap of the light absorbing layer of the second solar cell 201 is smaller than the band gap of the p-type light-absorbing layer 3 of the first solar cell 100. The multi-junction solar cell 200 according to this embodiment may also include a solar cell consisting of three or more solar cells joined together.

The band gap of the p-type light absorbing layer (cuprous oxide) 3 of the first solar cell 100 according to the first embodiment is about 2.0 [eV] or more and 2.2 [eV] or less. Therefore, the band gap of the light absorbing layer of the second solar cell 201 is preferably 1.0 [eV] or more and 1.6 [eV] or less. As the light-absorbing layer of the second solar cell 201, one or more compound semiconductor layers selected from the group consisting of CIGS-type and CdTe-type with a high In content ratio, crystalline silicon, and perovskite type compounds are preferable.

### (THIRD EMBODIMENT)

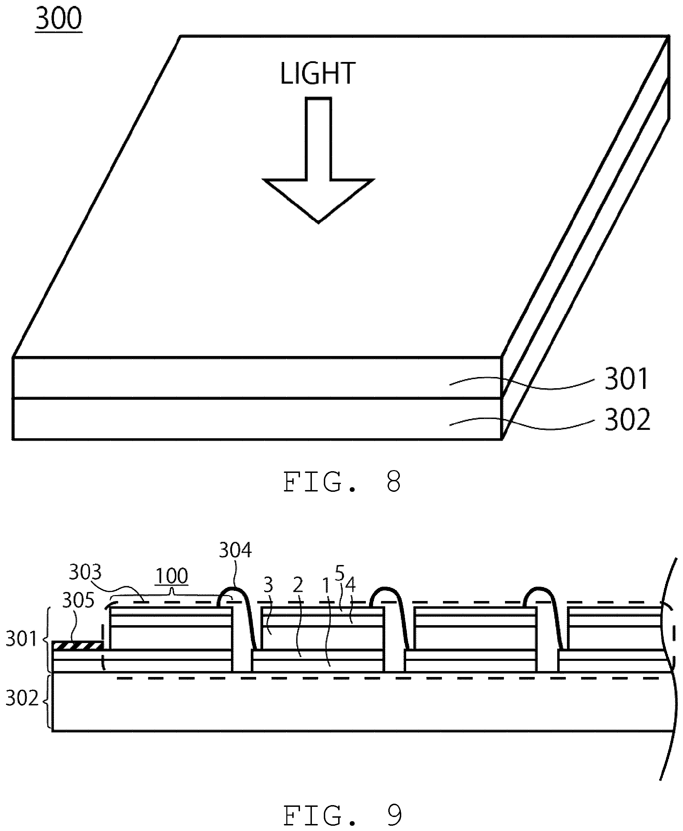

A third embodiment relates to a solar cell module. FIG. 8 shows a perspective diagram of the solar cell module 300 according to the fifth embodiment. The solar cell module 300 in FIG. 8 is a solar cell module where a first solar cell module 301 and a second solar cell module 302 are stacked. The first solar cell module 301 is on the light incident side and uses the first solar cell 100 according to the first embodiment. The second solar cell module 302 preferably uses the second solar cell 201.

FIG. 9 shows a cross-sectional diagram of the solar cell module 300. FIG. 9 details the structure of the first solar cell module 301, but does not show the structure of the second solar cell module 302. The structure of the solar cell module can be selected appropriately according to the light-absorbing layer used in the solar cell employed in the second solar cell module 302. The solar cell module 300 in FIG. 9 includes a plurality of broken-line enclosed submodules 303, each including multiple solar cells 100 (solar cells) arranged side by side and electrically connected in series via wiring 304. These submodules 303 are further electrically connected in parallel or series. Adjacent submodules 303 are electrically connected by busbars 305.

The adjacent solar cells 100 have their n-electrode 5 on the upper side and p-electrode 2 on the lower side connected by wiring 304. The solar cell 100 of the third embodiment, like that of the first embodiment, comprises the substrate 1, the p-electrode 2, the insulating film 3, the p-type light-absorbing layer 3, the n-type layer 4, and then n-electrode 5 (the intermediate film 6 is also included but not shown in FIG. 9). The busbars 305 connect to both ends of the solar cells 100 in each submodule 303, and are configured to adjust the output voltage with the second solar cell module 302 by connecting multiple submodules 303 electrically in parallel or series. The connection configuration of the solar cell 100 shown in this third embodiment is just one example, and a solar cell module can be configured using other connection configurations.

### (FOURTH EMBODIMENT)

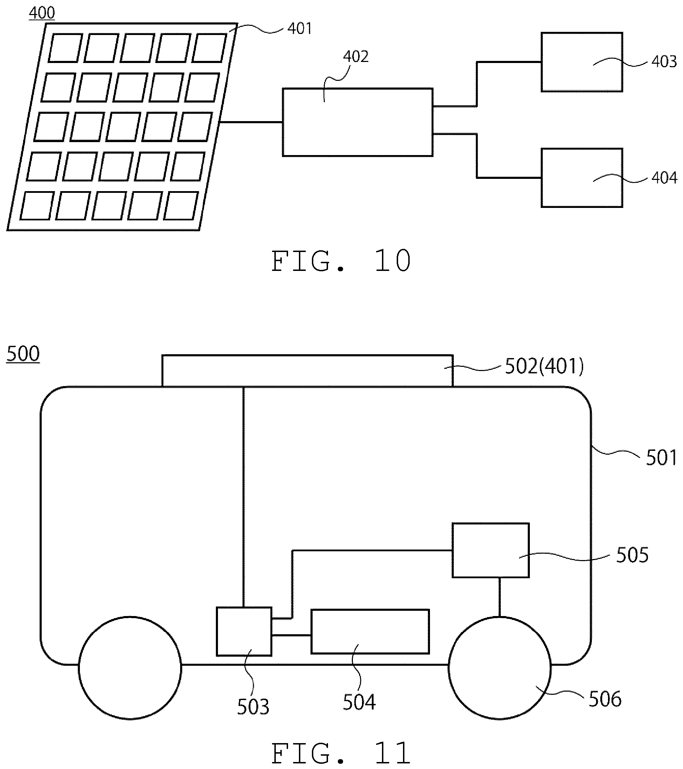

A fourth embodiment relates to a photovoltaic power generation system. The solar cell module of the third embodiment can be used as a generator for power generation in the photovoltaic power generation system of this embodiment. The photovoltaic power generation system of this embodiment generates electricity using a solar cell module and specifically includes a solar cell module that generates electricity, unit for converting the generated electricity into power, unit for storing the generated electricity (an accumulator), or a load for consuming the generated electricity. FIG. 10 shows a configuration diagram of the photovoltaic power generation system 400 according to this embodiment. The photovoltaic power generation system shown in FIG. 10 comprises a solar cell module 401 (300), a converter 402, a storage battery 403, and a load 404. Either the storage battery 403 or the load 404 may be omitted. The load 404 may also be configured to utilize electrical energy stored in the storage battery 403. The converter 402 is a device that includes a circuit or element for performing power conversion, such as voltage transformation or DC-AC conversion, including a DC-DC converter, a DC-AC converter, an AC-AC converter, etc. The configuration of the converter 402 should be appropriately selected according to the generation voltage or the configurations of the storage cell 403 and the load 404.

Electricity generated by solar cells included in the submodules 303 receiving light in the solar cell module 401 is converted by the converter 402 and stored in the storage battery 403 or consumed by the load 404. The solar cell module 401 may be provided with a solar tracking drive device for always directing the solar cell module 401 towards the sun, or a concentrator for focusing sunlight to improve the power generation efficiency.

The photovoltaic power generation system 400 is preferably used in real estate such as residences, commercial facilities, and factories, or movable property such as vehicles, aircraft, and electronic devices. By using a highly efficient solar cell according to this embodiment in the solar cell module, an increase in power generation can be expected.

As an example of using the photovoltaic power generation system 400, a vehicle will be explained. FIG. 11 shows a conceptual diagram of the vehicle 500. The vehicle 500 shown in FIG. 11 includes a vehicle body 501, a solar cell module 502, a power conversion device 503, a storage battery 504, a motor 505, and tires (wheels) 506. Electricity generated by the solar cell module 502 mounted on the top of the car body 501 is converted by the power conversion device 503 and charged into the storage battery 504 or consumed as power by a load such as the motor 505. The vehicle 500 can be driven by rotating the tires (wheels) 506 with the motor 505 using electricity supplied from the solar cell module 502 or the storage cell 504. The solar cell module 401 is used for the solar cell module 502. The solar cell module 502 may consist only of the first solar cell module equipped with the solar cell 100 according to the first embodiment, rather than a multi-junction type. When the transparent solar cell module 502 is adopted, it is also preferable to use the solar cell module 502 as a power generating window not only on the top of the vehicle body 501 but also on the side of the vehicle body 501.

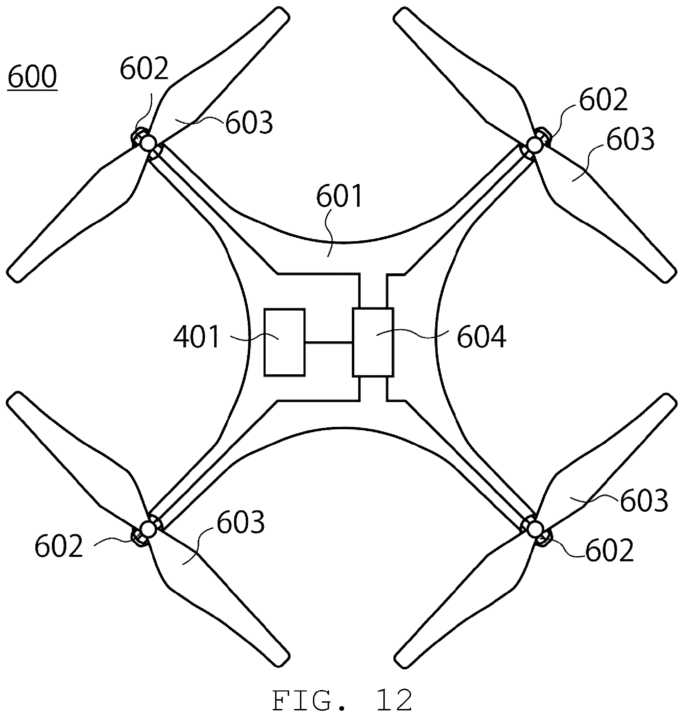

As an example of using the photovoltaic power generation system 400, a drone (quadcopter) will be explained. The drone uses the solar cell module 401. A simplified explanation of the configuration of the drone according to this embodiment will be given by referring to FIG. 12, a schematic diagram of the drone 600. The drone 600 comprises the solar cell module 401, a fuselage frame 601, a motor 602, a rotor 603, and a control unit 604. The solar cell module 401, the motor 602, the rotor 603, and the control unit 604 are arranged on the fuselage frame 601. The control unit 604 converts and adjusts the output power from the solar cell module 401. The motor 602 rotates the rotor 603 using the electricity supplied from the solar cell module 401. By adopting this configuration of the drone 600 with the solar cell module 401 according to this embodiment, it is possible to provide a drone capable of flying using more power.

Hereinafter, the present invention will be described in more detail with reference to examples, but the present invention is not limited to these examples.

### (EXAMPLE A)

### (Example A1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by sequentially depositing a Zn-including compound precursor and water as an oxidizing agent, followed by an Al-including compound precursor and water as an oxidizing agent using the ALD method. This process allows Zn to diffuse into the p-type light-absorbing layer 3, resulting in the formation of an intermediate film 6 that is very thin film including Zn and Al, and has a coverage ratio of 75 % on the surface of the p-type light-absorbing layer 3. Subsequently, a Ga₂O₃ film with a thickness of 10 [nm] is formed as the n-type layer 4. Finally, an AZO (ZnO : Al) with a thickness of 0.1 [µm] is formed as the n-electrode 5 to obtain a solar cell 100.

A solar simulator simulating an AM1.5G light source is used, and the light intensity is adjusted so that 1 sun is obtained using a standard Si cell under the light source. Measurement is conducted at atmospheric pressure with a room temperature of 25 [°C]. The voltage is swept, and the short-circuit current density Jsc (current divided by the cell area) is measured. On a graph with voltage on the horizontal axis and current density on the vertical axis, the point where the horizontal axis intersects is the open-circuit voltage Voc. On the measurement curve, when the product of voltage and short-circuit current density is maximized, these points are Vmpp and Jmpp (maximum power point), respectively. Then, FF = (Vmpp × Jmpp) / (Voc × Jsc) gives the fill factor. The conversion efficiency Eff. can be calculated from Eff. = Voc × Jsc × FF.

When the transmittance of light of the example A1 in the wavelength band of 700 [nm] or more and 1000 [nm] or less is 75% or more, transmittance is evaluated as A. When the transmittance of light of the example A1 in the wavelength band is 70% or more and less than 70%, transmittance is evaluated as B. When the transmittance of light of the example A1 in the wavelength band is less than 70%, transmittance is evaluated as C. The evaluation of transmittance is common to Example A and examples other than Example A.

When Jsc of the example A1 is 1.01 times or more Jsc of the comparison example, Jsc is evaluated as A. When Jsc is of the example A1 is 1.0 times or more and less than 1.01 times Jsc of the comparison example, Jsc is evaluated as B. When Jsc of the example A1 is less than 1.0 times Jsc of the comparison example, Jsc is evaluated as C. The evaluation of Jsc is common to Example A and examples other than Example A.

When Voc of the example A1 is 1.02 times or more Voc of the comparison example, Voc is evaluated as A. When Voc is of the example A1 is 1.00 times or more and less than 1.02 times Voc of the comparison example, Voc is evaluated as B. When Voc of the example A1 is less than 1.00 times Voc of the comparison example, Voc is evaluated as C. The evaluation of Voc is common to Example A and examples other than Example A.

When FF of the example A1 is 1.01 times or more FF of the comparison example, FF is evaluated as A. When FF is of the example A1 is 1.00 times or more and less than 1.01 times FF of the comparison example, FF is evaluated as B. When FF of the example A1 is less than 1.00 times FF of the comparison example, FF is evaluated as C. The evaluation of FF is common to Example A and examples other than Example A.

When the conversion efficiency of the example A1 is 1.04 times or more a conversion efficiency of the comparison example, the conversion efficiency is evaluated as A. When the conversion efficiency is of the example A1 is 1.00 times or more and less than 1.04 times the conversion efficiency of the comparison example, the conversion efficiency is evaluated as B. When the conversion efficiency of the example A1 is less than 1.00 times the conversion efficiency of the comparison example, the conversion efficiency is evaluated as C. The evaluation of the conversion efficiency is common to Example A and examples other than Example A.

### (Comparative Example (Comparative-EX) A1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, a Ga₂O₃ film with a thickness of 10 [nm] is formed as the n-type layer 4. Finally, an AZO (ZnO : Al) with a thickness of 0.1 [µm] is formed as the n-electrode 5 to obtain a solar cell 100 without the intermediate film 6. The solar cell of Comparative Example A1 is evaluated similarly to Example A1.

### (Comparative Example A2)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by depositing an Al-including compound precursor and water as an oxidizing agent using the ALD method, resulting in the formation of an intermediate film 6 that is very thin film including Zn and Al, and has a coverage ratio of 75% on the surface of the p-type light-absorbing layer 3. Subsequently, a Ga₂O₃ film with a thickness of 10 [nm] is formed as the n-type layer 4. Finally, an AZO (ZnO : Al) with a thickness of 0.1 [µm] is formed as the n-electrode 5 to obtain a solar cell 100. The solar cell of Comparative Example A2 is evaluated in the same way as in Example A1.

### (Example A2)

A solar cell is obtained similarly to Example A1, except that a Mg-including compound is used as the ALD precursor instead of the Zn-including compound. The solar cell of Example A2 is evaluated similarly to Example A1.

### (Example A3)

A solar cell is obtained similarly to Example A1, except that a Cd-including compound is used as the ALD precursor instead of the Zn-including compound. The solar cell of Example A3 is evaluated similarly to Example A1.

### (Example A4)

A solar cell is obtained similarly to Example A1, except that a Ca-including compound is used as the ALD precursor instead of the Zn-including compound. The solar cell of Example A4 is evaluated similarly to Example A1.

### (Example A5)

A solar cell is obtained similarly to Example A1, except that an Hf-including compound was used as the ALD precursor instead of the Al-including compound. The solar cell of Example A5 is evaluated similarly to Example
A1.

### (Comparative Example A3)

A solar cell is obtained similarly to Comparative Example A2, except that the Hf-including compound (no other precursor) used as the ALD precursor instead of the Al-including compound in Example A5 is used. The solar cell of Comparative Example A3 is evaluated similarly to Example A1.

### (Example A6)

A solar cell is obtained similarly to Example A1, except that a Zr-including compound is used as the ALD precursor instead of the Al-including compound. The solar cell of Example A6 is evaluated similarly to Example A1.

### (Comparative Example A4)

A solar cell is obtained similarly to Comparative Example A2, except that the Zr-including compound (no other precursor) used as the ALD precursor instead of the Al-including compound in Example A6 is used. The solar cell of Comparative Example A4 is evaluated similarly to Example A1.

### (Example A7)

A solar cell is obtained similarly to Example A1, except that a B-including compound is used as the ALD precursor instead of the Al-including compound. The solar cell of Example A7 is evaluated similarly to Example A1.

### (Comparative Example A5)

A solar cell is obtained similarly to Comparative Example A2, except that the B-including compound (no other precursor) used as the ALD precursor instead of the Al-including compound in Example A7 is used. The solar cell of Comparative Example A5 is evaluated similarly to Example A1.

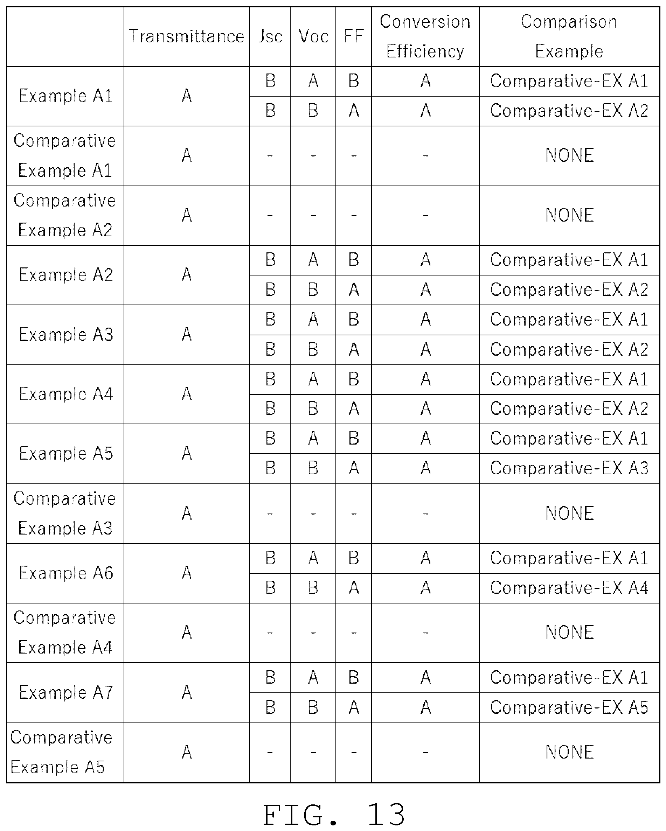

The evaluation results of the solar cells of Example A are shown in the table of FIG. 13. The results from Examples A1 to A4 showed good results compared to Comparative Examples A1 and A2, regardless of whether the first element is Zn, Mg, Cd,
or Ca. Good results are also obtained compared to the comparison examples even when the second element is changed from Al used in Examples A1 to A4 to Hf, Zr, or B. Compared to Comparative Example A1, which do not have either intermediate film 6 or region 3a, the Voc and conversion efficiency of Example A are effectively improved. Also, compared to Comparative Example A2, which has intermediate film 6 but no region 3a, the FF and conversion efficiency of Example A are effectively improved.

In the examples where region 3a is formed, almost all of the first element in the p-type light-absorbing layer 3 is distributed in region 3a, resulting in improved Voc or FF and contributing to increased conversion efficiency.

### (Example B)

### (Example B1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by sequentially depositing a Zn-including compound precursor and water as an oxidizing agent, followed by an Al-including compound precursor and water as an oxidizing agent using the ALD method. This process allows Zn to diffuse into the p-type light-absorbing layer 3, resulting in the formation of an intermediate film 6 that is very thin film including Zn and Al, and has a coverage ratio of 75% on the surface of the p-type light-absorbing layer 3. Subsequently, a Ga₂O₃ film with a thickness of 10 [nm] is formed as the n-type layer 4 (first n-type layer). On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100. The solar cell of Example B1 is evaluated similarly to Example A1.

### (Comparative Example B1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, a Ga₂O₃ film with a thickness of 10 [nm] is formed as the n-type layer 4 (the first n-type layer). On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100 without the intermediate film 6. The solar cell of Comparative Example B1 is evaluated similarly to Example A1.

### (Comparative Example B2)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by depositing an Al-including compound precursor and water as an oxidizing agent using the ALD method, resulting in the formation of an intermediate film 6 that is very thin film including Zn and Al, and has a coverage ratio of 75 % on the surface of the p-type light-absorbing layer 3. Subsequently, a Ga₂O₃ film with a thickness of 10 [nm] is formed as the n-type layer 4. On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100. The solar cell of Comparative Example B2 is evaluated in the same way as in Example A1.

### (Example B2)

A solar cell is obtained similarly to Example B1, except that a Mg-including compound is used as the ALD precursor instead of the Zn-including compound. The solar cell of Example B2 is evaluated similarly to Example A1.

### (Example B3)

A solar cell is obtained similarly to Example B1, except that a Cd-including compound is used as the ALD precursor instead of the Zn-including compound. The solar cell of Example B3 is evaluated similarly to Example A1.

### (Example B4)

A solar cell is obtained similarly to Example B1, except that a Ca-including compound is used as the ALD precursor instead of the Zn-including compound. The solar cell of Example B4 is evaluated similarly to Example A1.

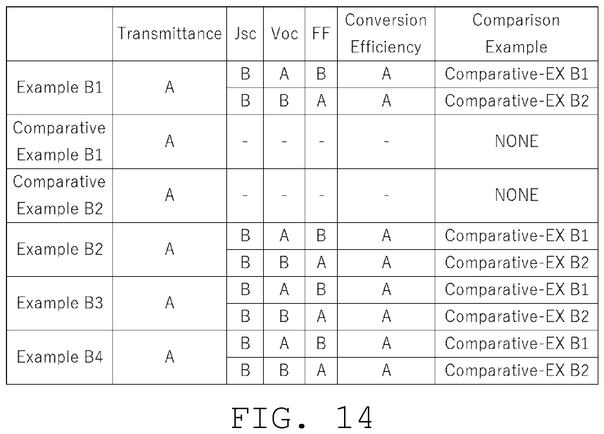

The evaluation results of the solar cells of Example B are shown in the table of FIG. 14. Similar to Example A, even when the n-type layer 4 is composed of two layers in Examples and Comparative Examples, good results are obtained compared to Comparative Examples B1 and B2, regardless of whether the first element is Zn, Mg, Cd, or Ca. Compared to Comparative Example B1, which has neither intermediate film 6 nor region 3a, the Voc and conversion efficiency of Example B are effectively improved. Also, compared to Comparative Example B2, which had intermediate film 6 but no region 3a, the FF and conversion efficiency of Example B are effectively improved.

In the examples where the region 3a is formed, almost all of the first element in the p-type light-absorbing layer 3 is distributed in the region 3a, resulting in improved Voc or FF and contributing to increased conversion efficiency.

### (Example C)

### (Example C1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by sequentially depositing a Zn-including compound precursor and water as an oxidizing agent, followed by an Al-including compound precursor and water as an oxidizing agent using the ALD method. This process allows Zn to diffuse into the p-type light-absorbing layer 3, resulting in the formation of an intermediate film 6 that is very thin film including Zn and Al, and has a coverage ratio of 10% on the surface of the p-type light-absorbing layer 3. Subsequently, a Ga₂O₃ film with a thickness of 10 [nm] is formed as the n-type layer 4 (first n-type layer). On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100. The solar cell of Example C1 is evaluated similarly to Example A1.

### (Comparative Example C1)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, a Ga₂O₃ film with a thickness of 10 [nm] is formed as the n-type layer 4 (the first n-type layer). On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100 without the intermediate film 6. The solar cell of Comparative Example C1 is evaluated similarly to Example A1.

### (Comparative Example C2)

On a glass substrate 1, as the p-electrode 2 on the back side, ITO (In : Sn = 80 : 20, film thickness 150 [nm]) and ATO (Sn : Sb = 98 : 2, film thickness 100 [nm]) are deposited on the side in contact with the glass. The thickness of the white glass substrate 1 is 0.5 [mm]. Subsequently, a Cu₂O layer as the p-type absorbing layer 3 with a thickness of 6 [µm] is formed on the p-electrode 2 by a sputtering method in an oxygen and argon gas atmosphere. After forming the p-type light-absorbing layer 3, the intermediate film 6 is formed by depositing an Al-including compound precursor and water as an oxidizing agent using the ALD method, resulting in the formation of an intermediate film 6 that is very thin film including Zn and Al, and has a coverage ratio of 10 % on the surface of the p-type light-absorbing layer 3. Subsequently, a Ga₂O₃ film with a thickness of 10 [nm] is formed as the n-type layer 4. On the Ga₂O₃, a ZnSnO (Zn : Sn = 80 : 20) film with a thickness of 14 [nm] is formed as the second n-type layer. Finally, an AZO (ZnO : Al) with a thickness of 0.1 [µm] is formed as the n-electrode 5 to obtain a solar cell 100. The solar cell of Comparative Example C2 is evaluated in the same way as in Example A1.

### (Example C2)

A solar cell is obtained similarly to Example C1, except that the intermediate film 6 is formed to satisfy the coverage ratio of 30%. The solar cell of Example C2 is evaluated similarly to Example A1.

### (Comparative Example C3)

A solar cell is obtained similarly to Comparative Example C2, except that the intermediate film 6 is formed to satisfy the coverage ratio of 30%. The solar cell of Comparative Example C3 is evaluated similarly to Example A1.

### (Example C3)

A solar cell is obtained similarly to Example C1, except that the intermediate film 6 is formed to satisfy the coverage ratio of 50%. The solar cell of Example C3 is evaluated similarly to Example A1.

### (Comparative Example C4)

A solar cell is obtained similarly to Comparative Example C2, except that the intermediate film 6 is formed to satisfy the coverage ratio of 50%. The solar cell of Comparative Example C4 is evaluated similarly to Example A1.

### (Example C4)

A solar cell is obtained similarly to Example C1, except that the intermediate film 6 is formed to satisfy the coverage ratio of 85%. The solar cell of Example C4 is evaluated similarly to Example A1.

### (Comparative Example C5)

A solar cell is obtained similarly to Comparative Example C2, except that the intermediate film 6 is formed to satisfy the coverage ratio of 85%. The solar cell of Comparative Example C5 is evaluated similarly to Example A1.

### (Example C5)

A solar cell is obtained similarly to Example C1, except that the intermediate film 6 is formed to satisfy the coverage ratio of 90%. The solar cell of Example C5 is evaluated similarly to Example A1.

### (Comparative Example C6)

A solar cell is obtained similarly to Comparative Example C2, except that the intermediate film 6 is formed to satisfy the coverage ratio of 90%. The solar cell of Comparative Example C6 is evaluated similarly to Example A1.

### (Example C6)

A solar cell is obtained similarly to Example C1, except that the intermediate film 6 is formed to satisfy the coverage ratio of 95%. The solar cell of Example C6 is evaluated similarly to Example A1.

### (Comparative Example C7)

A solar cell is obtained similarly to Comparative Example C2, except that the intermediate film 6 is formed to satisfy the coverage ratio of 95%. The solar cell of Comparative Example C7 is evaluated similarly to Example A1.

### (Example C7)

A solar cell is obtained similarly to Example C1, except that the intermediate film 6 is formed to satisfy the coverage ratio of 99%. The solar cell of Example C7 is evaluated similarly to Example A1.

### (Comparative Example C8)

A solar cell is obtained similarly to Comparative Example C2, except that the intermediate film 6 is formed to satisfy the coverage ratio of 99%. The solar cell of Comparative Example C8 is evaluated similarly to Example A1.

### (Comparative Example C9)

A solar cell is obtained similarly to Example C1, except that the intermediate film 6 is formed to satisfy the coverage ratio of 100% and has a thickness of 3 [nm]. The solar cell of Comparative Example C9 is evaluated similarly to Example A1.

### (Comparative Example C10)

A solar cell is obtained similarly to Comparative Example C2, except that the intermediate film 6 is formed to satisfy the coverage ratio of 100% and has a thickness of 3 [nm]. The solar cell of Comparative Example C9 is evaluated similarly to Example A1.

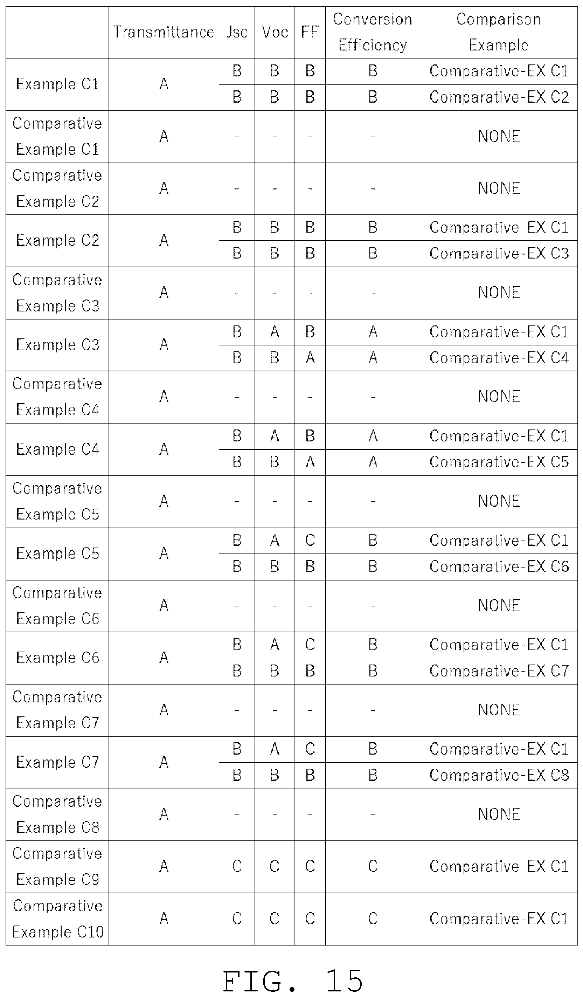

The evaluation results of the solar cells of Example C are shown in the table of FIG. 15. In Example C and Comparative Example C, the coverage ratio of intermediate film 6 is changed from 10% to 99% to evaluate the relationship between the coverage ratio and characteristics. In Examples C1 to C2 where the coverage ratio is 10% to 30%, Jsc, Voc, FF, and conversion efficiency are not significantly improved compared to the corresponding Comparative Example C. When the coverage ratio exceeded 50%, Voc or FF and conversion efficiency are improved similarly to Examples A and B. Compared to Comparative Example C1 where neither intermediate film 6 nor region 3a existed, Voc and conversion efficiency of Examples C3 and C4 are effectively improved. Conversion efficiency is improved by providing the intermediate film 6 as long as the coverage ratio is less than 100%. Also, when the intermediate film 6 with a low coverage ratio existed but the region 3a do not exist (Comparative Example C2), FF and conversion efficiency of Examples C3 and C4 are effectively improved. When the thickness of intermediate film 6 is set to 3 [nm], which is equivalent to a passivation film, the power
generation characteristics of Comparative Example C9 and Comparative Example C10, which are modified examples of Comparative Example C1, are degraded.

In the examples where the region 3a is formed, almost all of the first element in the p-type light-absorbing layer 3 is distributed in the region 3a, resulting in improved Voc or FF and contributing to increased conversion efficiency.

In the specification, some elements are represented only by chemical symbols for elements.
included[0152] While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A solar cell (100) comprising:
a p-electrode (2);
an n-electrode (5);
a p-type light-absorbing layer (3) on the p-electrode (2), comprising a cuprous oxide compound as a main component; and
an n-type layer (4) between the p-type light-absorbing layer (3) and the n-electrode (5), wherein
the p-type light-absorbing layer (3) incudes a first element selected from the group consisting of Zn, Mg, Cd, and Ca on the n-type layer (4) side,
the p-type light-absorbing layer (3) is in direct contact with the n-type layer (4), and
a concentration of the first element in a region from an interface between the p-type light-absorbing layer (3) and the n-type layer (4) to a depth of 50 [nm] or less toward the p-electrode side is 90 [atomic%] or more and 100 [atomic%] or less of a concentration of the first element included in the p-type light-absorbing layer (3).

2. The solar cell (100) according to claim 1, further comprising an intermediate film (6) comprising a compound of a second element, wherein
a coverage ratio of the p-type light-absorbing layer (3) by the intermediate film (6) is 10% or more and less than 100%,
the second element is one or more selected from the group consisting of Al, Hf, Zr, and B,
the cuprous oxide is in direct contact with the compound of the second element and the n-type layer (4).

3. The solar cell (100) according to claim 2, wherein
the intermediate film (6) comprises an oxide of the first element.

4. The solar cell (100) according to claim 3, wherein
a concentration of the first element included in the intermediate film (6) is 5 [atomic%] or more and 50 [atomic%] or less of the first element included in the p-type light-absorbing layer (3).

5. The solar cell according to any one of claims 1 to 4, wherein
a concentration of the first element included in a region (3a) is 1 [atomic%] or more and 10 [atomic%] or less of the concentration of copper element included in the region, and
the region (3a) extends from the interface between the p-type light-absorbing layer (3) and the n-type layer (4) to a depth of 50 [nm] or less toward the p-electrode (2) side.

6. The solar cell (100) according to any one of claims 1 to 5, wherein
the first element comprises at least Zn.

7. The solar cell (100) according to claim 2, wherein
a concentration the first element is 5 [atomic%] or more and 50 [atomic%] or less among metal elements included in the intermediate film (6).

8. The solar cell (100) according to claim 3 or 4, wherein
the total concentration of the first element and the second element among the metal elements included in the intermediate film (6) is 95 [atomic%] or more and 100 [atomic%] or less.

9. The solar cell (100) according to any one of claims 2 to 8, wherein
the intermediate film (6) comprises a compound represented by Alₓ₁Hfₓ₂Zrₓ₃Bₓ₄O_{y} where x1, x2, x3, x4 and y satisfy 0.8 ≤ x1 + x2 + x3 + x4 ≤ 1.2 and 0.3 ≤ (x1 + x2 + x3 + x4) / y ≤ 0.8.

10. The solar cell (100) according to any one of claims 2 to 9, wherein
the coverage ratio is 30% or more and 85% or less.

11. The solar cell (100) according to any one of claims 2 to 10, wherein
the coverage ratio is 50% or more and 85% or less.

12. The solar cell (100) according to claim 3 or 8, wherein
an average thickness of the intermediate film (6) is 0.2 [nm] or more and 1 [nm] or less.

13. The solar cell (100) according to claim 3, 8, or 12, wherein
a maximum thickness of the intermediate film (6) is 0.2 [nm] or more and 1 [nm] or less.

14. The solar cell (100) according to claim 3, 8, 12, or 13, wherein
one or more side surfaces of the intermediate film (6) is in direct contact with the n-type layer (4).

15. The solar cell (100) according to claim 3, 8, 12, 13, or 14, wherein
all surfaces other than one or more surfaces of the intermediate film (6) facing the p-type light-absorbing layer (3) are in direct contact with the n-type layer (4).
